Europäisches Patentamt

European Patent Office

Office européen des brevets

(19)

(11) Publication number: **0 015 053**

**A1**

(12)

# EUROPEAN PATENT APPLICATION

(21) Application number: **80300125.4**

(22) Date of filing: **15.01.80**

(51) Int. Cl.³: **H 01 L 23/02**
**H 01 L 23/36**

(30) Priority: **27.01.79 GB 7902953**

(43) Date of publication of application:
**03.09.80 Bulletin 80/18**

(84) Designated Contracting States:
**DE FR GB IT NL**

(71) Applicant: **LUCAS INDUSTRIES LIMITED**
**Great King Street**
**Birmingham, B19 2XF(GB)**

(72) Inventor: **Whyte, Robert**
**Highfield, Chestnut Walk Henley in Arden**
**Solihull, West Midlands(GB)**

(72) Inventor: **Stacey, David William**
**91 Egginton Road**
**Hall Green Birmingham 28(GB)**

(74) Representative: **Carpenter, David et al,**
**MARKS & CLERK Alpha Tower ATV Centre**
**Birmingham B1 1TT(GB)**

(54) **A method of manufacturing a semi-conductor power device assembly and an assembly thereby produced.**

(57) A method of manufacturing a semiconductor power device assembly comprising providing on one surface of a heat sink plate (11), a thin layer (12) of an electrically insulating and thermally conductive material, the layer (12) being supported by the plate (11) and a semiconductor device (14, 15, 16) being secured thereto in heat exchange relationship therewith.

FIG.2.

This invention relates to a method of manufacturing an assembly including a semiconductor power device.

It is well known that during normal usage semiconductor power devices generate sufficient heat to necessitate, in many applications, an associated heat sink. Metals such as copper and aluminium having good thermal conductivity are often used to form heat sinks. It has previously been proposed to utilize aluminium plate as a heat sink in a semiconductor power device assembly wherein the device is electrically isolated from the heat sink plate by a tile of ceramic material. In this previously proposed device the ceramic tile carried printed circuit areas to one of which the power device was soldered. In order to achieve good thermal conduction between the device and the heat sink plate the ceramic tile carrying the printed circuit and the device was clamped to the plate with a layer of thermally conductive gel or grease interposed between the tile and the plate to fill any air gaps formed by the inherent non-planar surfaces of the plate and tile. In a second previously proposed assembly the ceramic tile having the printed circuit and device thereon was secured to the heat sink plate by means of a layer of thermally conductive adhesive. It is an object of the present invention to provide a method of manufacturing a semiconductor power device assembly resulting in an assembly of simpler and more efficient construction than the previously proposed assemblies.

A method of manufacturing a semiconductor power device assembly according to the invention includes the steps of starting with a heat sink plate, providing on one surface of the plate a thin layer of electrically insulating, thermally conductive material, said thin layer being supported by the plate, and securing a semiconductor power device to said layer in heat exchange relationship therewith.

Preferably said layer is provided with an electrically conductive surface region to which said device is secured.

Desirably said insulating layer is a ceramic material.

Preferably said ceramic layer is deposited on said plate by a spraying technique.

Conveniently said conductive surface region of said layer is part of an electrical conductor pattern on said layer.

Desirably said conductive surface region is provided on said layer by a screen printing technique.

Conveniently said heat sink plate is formed from aluminium.

Preferably said layer does not cover the whole of said surface of the plate, at least part of the surface of the plate not covered by said layer being in heat exchange relationship with an electrical circuit component carried on a ceramic tile located on said uncovered area of the plate.

One example of the invention is illustrated in the accompanying drawings wherein:-

Figure 1 is a diagrammatic perspective view of a semiconductor power device assembly, and

Figures 2 and 3 are sectional views (not to scale) on the lines 2-2 and 3-3 in Figure 1.

Referring to the drawings, the assembly includes an aluminium heat sink plate 11 of generally rectangular form. One end region of an upper planar surface of the plate 11 is coated with a layer 12 of an electrically insulating and thermally conductive ceramic material, conveniently alumina

The ceramic layer 12 is deposited on the plate 11 by a spraying operation using a known high energy plasma spray gun, for example the type of spray gun known as the METCO 7 MB manufactured by the firm of Metco of Westbury, Long Island, New York. The layer of ceramic material is relatively thin, so thin as to be reliant upon the plate 11 for its structural integrity. Thus the layer is of a thickness such that it could not be handled, for subsequent processing, if it were separate from the plate 11. One of the major factors governing the thickness of the layer 12 is that it should be capable of electrically isolating conductive components on the layer from the conductive plate 11. Thus the thickness will be determined to a large extent by the voltage difference which will exist in use between opposite sides of the layer.

An electrical conductor 13 in a predetermined pattern is next provided on the exposed surface of the ceramic layer 12 by any convenient technique. For example, well known printed circuit techniques may be used to provide the conductor pattern 13 on the ceramic layer 12. Thus in one particular arrangement the conductor pattern 13 is silk screen printed onto the layer 12 utilizing a conductive ink which is subsequently fused onto the surface of the ceramic layer at high temperature. It will be recognised that if a high temperature fusing operation is utilized in the production of the conductor pattern then the choice of material from which the heat sink plate 11 is formed will be critical, since some conductive inks have a fusion temperature in excess of the melting point temperature of aluminium, and thus a copper plate 11, having a higher melting temperature than an alumimium plate, might be chosen.

At the formation of the conductor pattern 13 three semiconductor power devices 14, 15, 16 are connected by soldering to the conductor pattern 13. The devices 14, 16 in the example shown in the drawings are power diodes and the device 15 is a power transistor. Each device 14, 15, 16 is in the form of an unprotected silicon chip, the transistor chip 15 having one of its terminal regions electrically and physically connected to the conductor pattern 13 by the solder. The devices 14, 15, 16 have two terminal regions exposed on their face remote from the conductor pattern 13, and electrical connections are made thereto by means of conventional connector strips 17. One of the two connector strips connected to each of the devices 15, 16 serves to connect a respective terminal region to the heat sink plate 11 by way of apertures in the ceramic layer 12. One of the connector strips of the device 14 serves to connect a terminal region of the device 14 to an external connector 18 to be described in more detail hereinafter. It will be recognised that the devices 14, 15, 16 are in heat exchange relationship with the layer 12, the heat generated by the devices in use being conducted by the layer 13 to the plate 11 where the heat is absorbed.

Only part of the upper surface of the plate 11 is covered by the ceramic layer 12, and part of the exposed surface of the plate 11 is in heat exchange relationship with a self-supporting ceramic tile 19 carrying further devices on a conductor pattern thereon. Connections are made between the conductor pattern on the tile 19 and the devices 14, 15, 16 by way of the three remaining connector strips 17 of the three devices. The heat exchange relationship between the tile 19 and the plate 11 is not critical to the present invention, since the tile 19 will not usually carry power devices. However should simple facial contact between the plate 11 and the tile 19 prove inadequate then some physical clamping arrangement may be provided to clamp
the tile onto the plate, with, if necessary, a thermally
conductive gel or grease layer between the tile and the
plate. Alternatively, the tile 19 may be secured to the
plate by means of a thermally conductive adhesive.

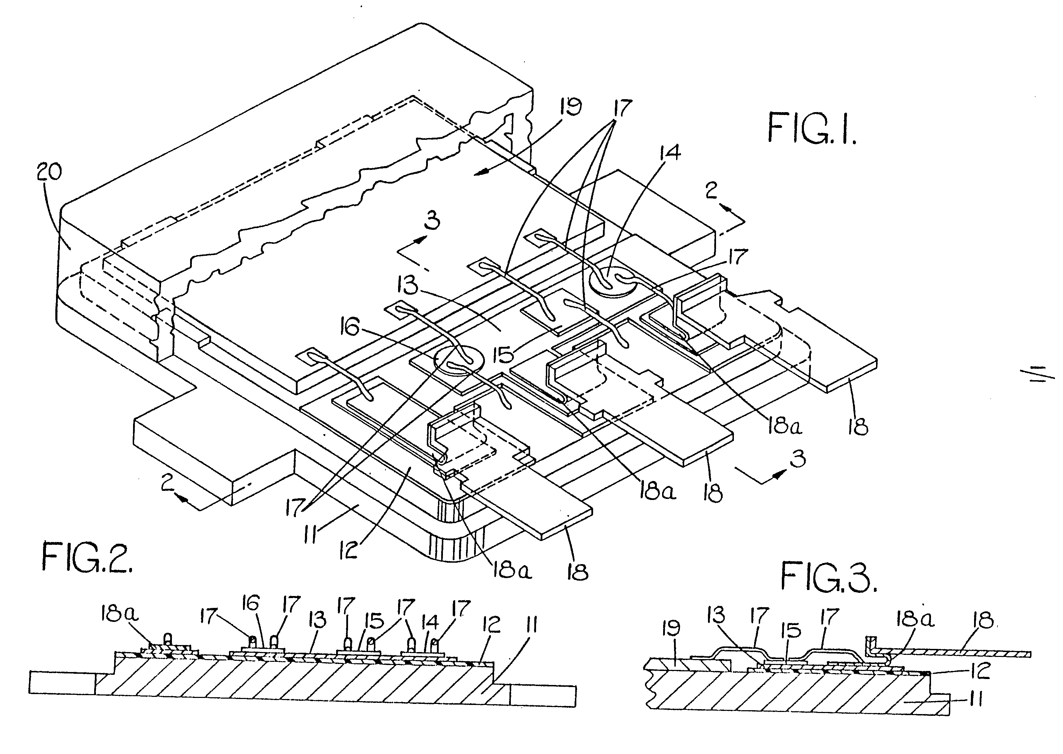

In order to provide for external electrical connections the assembly includes three connectors 18 which
project from the finished assembly. The three connectors
18 are formed from copper strip, and each is carried by
a moulded synthetic resin housing 20 which in use is attached to the tile. Each connector 18 includes a resilient
member 18a which is initially separate from its respective
connector 18. As can be seen in Figure 1 the member 18a
associated with the centre one of the three connectors 18
is electrically and physically connected to a part of the
conductor pattern 13 and thus is electrically connected to
one terminal region of the transistor chip 15. The resilient
members 18a of the two outermost connectors 18 are secured
to respective pads provided on the layer 12. The pads can
conveniently be formed on the layer 12 at the same time as
the conductor pattern 13, but primarily they serve no
electrical function, their purpose being to ensure that
their respective members 18a are at the same level as
the central member 18a and of course to facilitate the
securing of the members 18a to the layer 12. The member
18a adjacent the device 14 is electrically connected to
one terminal region of the device 14 by a strip 17, and
the remaining member 18a is electrically connected to the
conductor pattern on the tile 19 by way of a strip similar
to the strips 17. It will be recognised that all of the
electrical connections can be made within the assembly,
without the presence of the housing 20 and the connectors
18. Thus the assembly can be tested before the housing
20 is affixed to the plate 11. After fixing the housing
20 to the plate 11. After fixing the housing 20 to the plate 11 internally projecting portions of the connectors 18 are welded to their respective members 18a, the welding tool being inserted through an aperture in the housing 20. Thereafter the aperture in the housing 20 can be closed in any convenient manner, for example by a cover, or by introducing an electrically insulating encapsulant.

The assembly of the device is 14, 15, 16, the conductor pattner 13, the layer 12, and the heat sink 11 is believed to be advantageous over previously proposed assemblies wherein the devices 14, 15, 16 would be mounted on a self-supporting tile secured to the heat sink plate 11, in that it is cheaper, and more efficient. The saving in costs stems not only from the saving in ceramic material, but also from the simplicity of manufacture which results from the building of the assembly in stages using the plate 11 as the support. The increase in efficiency is achieved by virtue of the thin ceramic layer, rather than the use of a relatively thick self-supporting tile, the thin ceramic layer ensuring an efficient heat transfer between the devices 14, 15, 16 and the plate 11. Additionally the direct application of the thin ceramic layer to the plate 11 obviates the need found previously for a thermally conductive adhesive, or an interposed layer of thermally conductive gel or grease.

Mentioned above is the possibility of using a heat sink plate 11 formed from aluminium or copper dependent upon the manner in which the conductor pattern 13 is provided on the layer 12. Other alternatives include the use of materials other than ceramics to produce the layer 12, and methods other than high energy plasma spraying to deposit the electrically insulating layer 12 on the plate 11.

CLAIMS:

1. A method of manufacturing a semiconductor power device assembly characterised by providing, on one surface of a heat sink plate 11, a thin layer 12 of electrically insulating, thermally conductive material, said thin layer 12 being supported by the plate 11, and securing a semiconductor power device 14 (15, 16) to said layer in heat exchange relationship therewith.

2. A method as claimed in claim 1 characterised in that said layer 12 is provided with an electrically conductive surface region 13 to which said device 14 (15, 16) is secured.

3. A method as claimed in claim 1 or claim 2 characterised in that said insulating layer 12 is a ceramic material.

4. A method as claimed in claim 3 characterised in that said ceramic layer 12 is deposited on said plate by a spraying technique.

5. A method as claimed in anyone of chims 2 to 4 characterised in that said conductive surface regions 13 of said layer 12 is part of an electrical conductor pattern on said layer 12.

6. A method as claimed in anyone of claims 2 to 5 characterised in that said conductive surface region 13 is provided on said layer 12 by a screen printing technique.

7. A method as claimed in anyone of the preceding claims characterised in that said heat sink plate 11 is formed from aluminium.

8.    A method as claimed in anyone of the preceding claims characterised in that said layer 12 does not cover the whole of said surface of the plate 11, at least part of the surface of the plate 11 not covered by said layer 12 being in heat exchange relationship with an electrical circuit component carried on a ceramic tile 19 located on said uncovered area of the plate 11.

9.    A semiconductor power device assembly characterised in that it is manufactured by the method claimed in anyone of the preceding claims.

FIG.I.

FIG.2.

FIG.3.

European Patent Office

**EUROPEAN SEARCH REPORT**

Application number

EP 80 30 0125

| | DOCUMENTS CONSIDERED TO BE RELEVANT | | CLASSIFICATION OF THE APPLICATION (Int. Cl.3) |
|---|---|---|---|
| Category | Citation of document with indication, where appropriate, of relevant passages | Relevant to claim | |
| X | <u>US – A – 3 958 195</u> (VARIAN ASSOCIATES)<br>* column 2, lines 31 to 50;<br>fig. 1 to 4 *<br>-- | 1-3,5,<br>8,9 | H 01 L 23/02<br>H 01 L 23/36 |
| X | <u>US – A – 3 784 883</u> (COMMUNICATIONS TRANSISTOR)<br>* column 2, lines 25 to 64;<br>column 4, line 64 to column 5,<br>line 7; fig. 4 and 5 *<br>-- | 1-3,5,<br>8,9 | |
| X | <u>GB – A – 1 404 100</u> (MOTOROLA)<br>* claim 1; page 2, lines 84 to 125;<br>fig. 1 and 2 *<br>-- | 1-3,9 | **TECHNICAL FIELDS SEARCHED (Int.Cl.3)**<br><br>H 01 L 23/02<br>H 01 L 23/08<br>H 01 L 23/36 |
| X | <u>DE – A1 – 2 811 933</u> (GENERAL ELECTRIC)<br>* claim 1; pages 6 and 7; fig. 1<br>and 2 *<br>-- | 1-3,8,<br>9 | |
| | <u>DE – A1 – 2 724 589</u> (R. BOSCH)<br>* claims 1, 5, 7; page 6; fig. 2 *<br>---- | 1,2,9 | **CATEGORY OF CITED DOCUMENTS**<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

The present search report has been drawn up for all claims

| Place of search<br>Berlin | Date of completion of the search<br>08-05-1980 | Examiner<br>ROTHER |
|---|---|---|

EPO Form 1503.1   06.78